# EUROPÄISCHE PATENTSCHRIFT

(11) **EP 0 309 679 B1**
(45) Veröffentlichungstag und Bekanntmachung des Hinweises auf die Patenterteilung: **15.09.1993**
(21) Anmeldenummer: 88112192.5
(22) Anmeldetag: 28.07.1988
(51) Int. Cl.: H01F 3/10, G11C 11/155

(54) **Spulenkern für eine induktive, frequenzunabhängige Schaltvorrichtung**
Core for an inductive, frequency-independent switching device
Noyau pour un dispositif inductif de commutation et indépendant de la fréquence

(30) Priorität: 03.09.1987 DE 3729418
(43) Veröffentlichungstag der Anmeldung: 05.04.1989
(73) Patentinhaber: Vacuumschmelze GmbH, 63450 Hanau (DE)
(72) Erfinder: Rauscher, Gerd, Dipl.-Phys., D-8755 Alzenau (DE)

(56) Entgegenhaltungen:
- EP-A- 0 156 016
- DE-A- 1 804 793
- DE-A- 1 815 127
- DE-A- 1 816 340
- DE-A- 2 019 935
- DE-A- 2 143 326
- DE-A- 2 416 557
- DE-C- 3 152 008
- IBM TECHNICAL DISCLOSURE BULLETIN, Band 6, Nr. 9, Februar 1964, Seiten 43-44, New York, US; J.S. JUDGE et al.: "Flux sensitive recording utilizing a stepped loop material on plated tape"

## Beschreibung

Die Erfindung betrifft einen Spulenkern für eine induktive, frequenzunabhängige Schaltvorrichtung nach dem Oberbegriff des Anspruchs 1.

Ein draht- oder stabförmiger Verbundkörper ist beispielsweise durch die DE-OS 34 11 079 bekannt. Der Verbundkörper besteht bei einem bevorzugten Ausführungsbeispiel aus einem drahtförmigen Kern und einem diesen umgebenden Mantel. Der Mantel ist beispielsweise aus einer Legierung mit 29 Gew.% Nickel, 17 Gew.% Kobalt und Rest Eisen gefertigt, während der Kern aus 50 Gew.% Kobalt, 2 Gew..% Vanadium und Rest Eisen besteht. Die beiden Legierungen weisen üblicherweise weichmagnetische Eigenschaften auf, wobei eine davon anisotrop ist. Sie haben verschiedene thermische Ausdehnungskoeffizienten, so daß nach einer Glühbehandlung des fertig gezogenen Verbundkörpers sich durch die anschließende Abkühlung Mantel und Kern verspannen und deswegen in Achsrichtung des Verbundkörpers eine magnetische Vorzugsrichtung entsteht. Beim Einwirken eines äußeren Magnetfeldes ändert sich beim Über- oder Unterschreiten einer bestimmten Feldstärke die Magnetisierungsrichtung im Verbundkörper mehr oder weniger sprunghaft, insbesondere auch in Abhängigkeit von der Länge des Verbundkörpers. Es hat sich gezeigt, daß bei relativ kurzen Verbundkörpern wegen besonderer Randeffekte eine sprunghaft Ummagnetisierung nicht mehr stattfindet.

Dieser Nachteil wird gemäß der DE-OS 34 11 079 dadurch beseitigt, daß man dem Verbundkörper einen in Richtung der Längsachse magnetisierten Dauermagneten zuordnet, vorzugsweise parallel dazu anordnet. Hierdurch wird die Hysteresekurve so verändert, daß unabhängig von der Größe und Änderungsgeschwindigkeit des einwirkenden äußeren Magnetfeldes beim Durchlaufen einer ganz bestimmten Feldstärke in einer Richtung ein frequenzunabhängiger Impuls in einer den Spulenkern umgebenden Spule erzeugt wird, und zwar auch bei extrem kurzen Spulenkernen.

Aus der DE-C1 31 52 008 ist ebenfalls ein langgestreckter magnetischer Schaltkern bekannt, der aus einem mindestens zweiteiligen Verbundkörper aus unterschiedlicchen Werkstoffen besteht, von denen mindestens einer magnetisierbar ist. Die Schaltkerne können Bereiche aus mindestens zwei magnetisierbaren Werkstoffen mit unterschiedlichen Koerzitivfeldstärken besitzen. Bei solchen magnetischen Schaltkernen können nacheinander mehrere Schaltungen erfolgen. Die in den Ausführungseispielen beschriebenen Schaltkerne weisen eine Länge von 100 mm auf.

Der Erfindung liegt die Aufgabe zugrunde, einen Spulenkern der im Oberbegriff des Patentanspruchs beschriebenen Art zu schaffen, der ebenfalls keine besonders große Länge erfordert, wie der in der DE-A 34 11 079 beschriebene Spulenkern, der jedoch in der Lage ist, pro Zyklus zwei Impulse abzugeben, wobei gleichbleibendes Impulsniveau für alle ausreichend hohen Feldamplituden gewährleistet ist.

Diese Aufgabe wird gemäß der Erfindung durch einen Spulenkern mit den Merkmalen des Anspruchs 1 gelöst. Vorteilhafte Weiterbildungen des erfindungsgemäßen Spulenkerns ergeben sich aus den Unteransprüchen.

Anhand der Zeichnung, in der mehrere Ausführungsbeispiele dargestellt sind, wird die Erfindung näher erläutert; es zeigen:
- Fig. 1: das Prinzip eines an sich bekannten Spulenkerns,
- Fig. 2: die Wirkungsweise des Spulenkerns gemäß Fig. 1 bei Wechselstrommagnetisierung,
- Fig. 3: eine Ausführungsform eines Spulenkerns gemäß der Erfindung,
- Fig. 4: in schematischer Darstellung die Wirkungsweise des Spulenkerns gemäß Fig. 3,
- Fig. 5: eine an einem konkreten Ausführungsbeispiel gemessene Hystereseschleife,
- Fig. 6: einen bei dem Ausführungsbeispiel gemäß Fig. 5 gemessenen Impuls,
- Fig. 7: eine schaubildliche Darstellung der Ausgangsspannung in Abhängigkeit von der Feldstärke
- Fig. 8: ein anderes Ausführungsbeispiel des erfindungsgemäßen Spulenkerns, insbesondere für höhere Frequenzen.

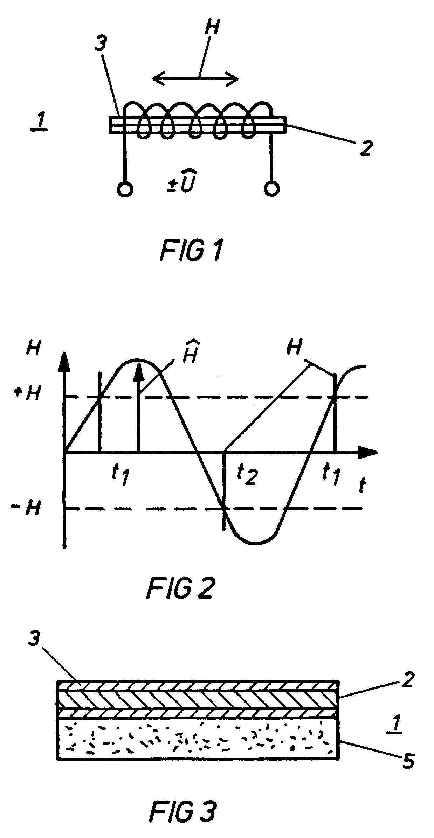

Der Spulenkern 1 gemäß Fig. 1 besteht aus einem drahtförmigen Kern 2 und einem diesen umgebenden Mantel 3. Wie bereits eingangs erwähnt, kann der Mantel 3 aus einer Legierung mit 29 Gew.% Nickel, 17 Gew.% Kobalt und Rest Eisen und der Kern 2 aus einer Legierung mit 50 Gew.% Kobalt, 2 Gew.% Vanadium und Rest Eisen bestehen, die in der zuvor beschrieben Weise behandelt werden, damit der zu einem Verbundkörper vereinigte Spulenkern 1 entsteht. Um den Spulenkern 1 ist eine Spule 4 gewickelt, in der beim Ummagnetisieren des Verbundkörpers (Kern 2 und / oder Mantel 3) Spannungen induziert werden.

In Fig. 2 ist der zeitliche Verlauf eines magnetischen Wechselfeldes dargestellt, wobei in der Ordinatenachse die Feldstärken +H und -H aufgetragen sind. Mit +Hs und -Hs sind die Schaltfeldstärken bezeichnet. Bei jedem Überschreiten der Schaltfeldstärken +Hs und -Hs wird der Spulenkern 1 ummagnetisiert, so daß bei einem Zyklus zwei Impulse in der Spule 4 induziert werden, und zwar zu den Zeitpunkten t1 und t2, die entgegengesetzt gepolt und frequenzunabhängig sind. Dies funktioniert jedoch nur dann zufriedenstellend, wenn die Länge des Spulenkerns entsprechend groß gewählt wird.

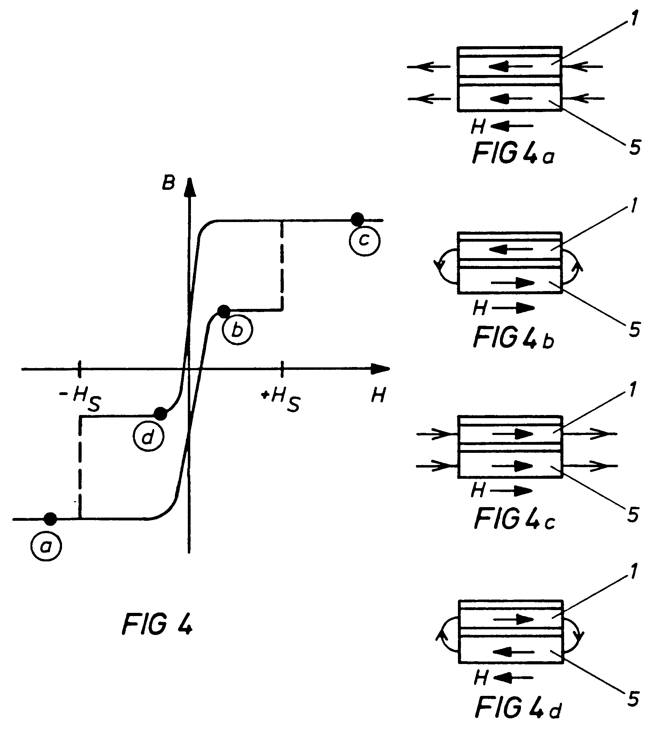

Um jedoch die Funktionsweise auch bei kurzen Spulenkernen sicherzustellen, ist gemäß der Erfindung dem Verbundkörper ein weichmagnetischer Körper 5 zugeordnet, der stab- oder drahtförmig ausgebildet sein kann, wie Fig. 3 zeigt. Gleichwirkende Teile sind mit den gleichen Bezugsziffern versehen. Er ist bei dem gewählten Ausführungsbeispiel fest mit dem Verbundkörper 1 verbunden. Der weichmagnetische Körper weist eine niedrigere Koerzitivfeldstärke auf als der schaltende ferromagnetische Teil des Verbundkörpers 1 (Kern und / oder Mantel). Wie anhand der Fig. 4 noch erläutert werden wird, weist der erfindungsgemäße Spulenkern gegenüber dem Spulenkern nach DE-OS 34 11 079 den Vorteil auf, daß pro Zyklus zwei Impulse erhalten werden bei gleichbleibendem Impulsniveau für alle ausreichend hohen Feldamplituden. Ferner ist eine Übersteuerung durch zu hohe Felder nicht möglich.

Fig. 4 zeigt die Hystereseschleife des erfindungsgemäßen Spulenkerns, wobei vier charakteristische Punkte a bis d eingetragen sind, deren entsprechende Magnetisierungszustände in den Fig. 4a bis 4d dargestellt sind. In Fig. 4a und in Fig. 4c sind Magnetisierungsrichtung im Verbundkörper und angelegte Feldstärke gleichgerichtet. Beim Übergang von Punkt a nach Punkt b, d. h. bei einer Verminderung der Feldstärke, versucht der weichmagnetische Körper 5 vorerst noch die Magnetisierung aufrechtzuerhalten. In den Punkten b und d jedoch ist die Magnetisierungsrichtung im weichmagnetischen Körper 5 kontinuierlich umgekehrt worden, wodurch der Streufluß des Verbundkörpers 1 über den weichmagnetischen Körper 5 magnetisch rückgeschlossen wird, wie Fig. 4b und 4d zeigen. Zusammen mit der Anisotropie des Verbundkörpers in Längsrichtung bedeutet dieses eine energetisch und magnetisch stabile Konfiguration, die ein gewisses Überschußfeld oberhalb der Koerzitivfeldstärke erfordert, bei der der Verbundkörper (d. h. sein schaltender, ferromagnetischer Teil) dann mit einem schnellen Flußsprung ebenfalls in Feldrichtung magnetisiert wird.

Durch den weichmagnetischen Rückschluß mit dem parallel zum Verbundkörper angelegten weichmagnetischen Körper steigen Impulsniveau und Reproduzierbarkeit erheblich an, insbesondere für kurze Spulenkerne. Auf diese Weise können Spulenkerne erhalten werden deren Länge gleich oder kleiner als 30 mm ist.

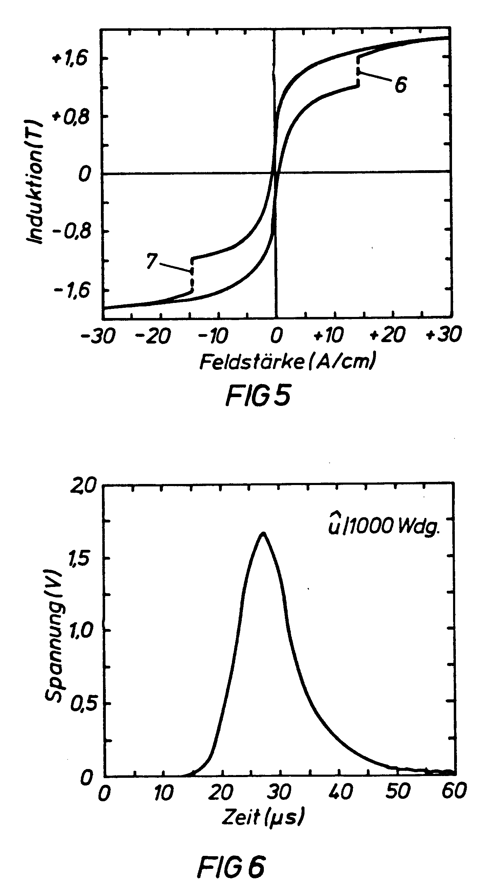

Fig. 5 zeigt die Hystereseschleife eines Spulenkerns, wobei der Verbundkörper 1 aus einem durchlaufgeglühten Draht aus VACON/VACOFLUX mit einem Durchmesser von 0,12 mm und einer Länge von 30 mm bestand, der mit einem stationär geglühten Draht aus VACOFLUX 50 mit einem Durchmesser von 0,20 mm und einer Länge von 30 mm kombiniert wurde. Die Ummagnetisierung wurde mit einer Frequenz von 1 Hz vorgenommen. Beim gestrichelten Kurvenstück 6 wird ein positiver und beim gestrichelten Kurvenstück 7 ein negativer Impuls abgegeben. Fig. 6 zeigt einen solchen gemessenen Impuls.

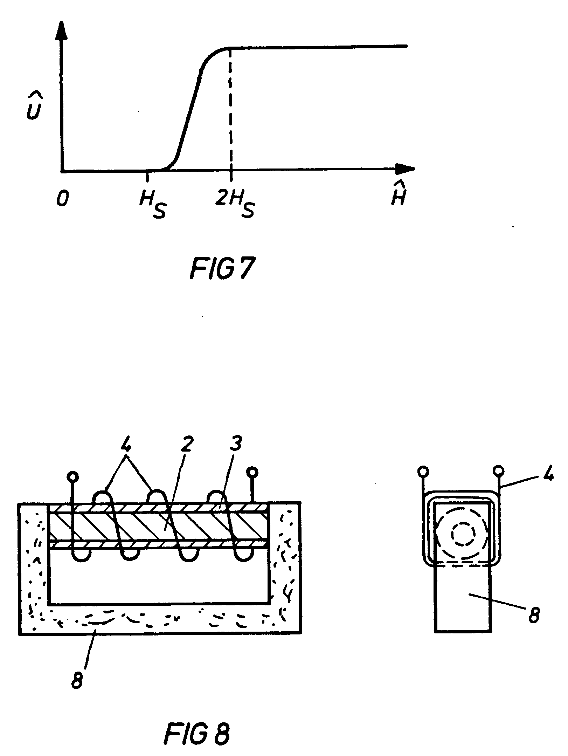

Wie Fig. 7 zeigt, setzen Impulse erst ein, wenn die Feldamplitude etwas oberhalb der Schaltfeldstärke Hs bzw. 2Hs liegt, wobei nach einem Übergang ab ca. 2Hs volles Impulsniveau zur Verfügung steht.

Im allgemeinen wird die Wicklung der Spule 4 auch den weichmagnetischen draht- oder stabförmigen Körper 5 gemäß Fig. 3 umfassen. Bei höheren Frequenzen kann dieses zu Sekundärimpulsen führen, die unter Umständen bei gewissen Anwendungen stören könnten. In Fig. 8 ist ein Ausführungsbeispiel dargestellt, bei dem Sekundärimpulse mit Sicherheit vermieden werden können. Gleichwirkende Teile sind mit gleichen Bezugsziffern versehen. Hierbei ist der weichmagnetische Körper 8 U-förmig ausgebildet. Die freien Enden der Schenkel liegen an den Enden des Verbundkörpers 1 an.

Der bidirektional schaltende Spulenkern gemäß der Erfindung ist besonders geeignet für magnetische Schwellwertgeber, Gleichstrom- und Wechselstrom-Grenzwertgeber, Drehzahl- und Positionssensoren und dergleichen mehr.

## Patentansprüche

1. Spulenkern für eine induktive, frequenzunabhängige Schaltvorrichtung mit einem draht- oder stabförmigen Verbundkörper (1), der aus mindestens zwei gegeneinander in Richtung der Längesache des Verbundkörpers mechanisch verspannten Teilen (2, 3) besteht, von denen mindestens eines ferromagnetisch ist und in Richtung der Längsachse anisotropische, weichmagnetische Eigenschaften besitzt, wobei dem Verbundkörper (1) ein zusätzlicher, mit diesem magnetostatisch gekoppelter, weichmagnetischer Körper (5) zugeordnet ist, der eine niedrigere Koerzitivfeldstärke als der mindestens eine schaltende ferromagnetische Teil (2 und / oder 3) des Verbundkörpers (1) aufweist und durch den der Streufluß des Verbundkörpers (1) magnetisch rückgeschlossen wird, **dadurch gekennzeichnet**, daß beim Schalten die Magnetisierungsrichtung im weichmagnetischen Körper (5) kontinuierlich umgekehrt wird.

2. Spulenkern nach Patentanspruch 1, **dadurch gekennzeichnet**, daß der Querschnitt des weichmagnetischen Körpers (5) so bemessen ist, daß er den magnetischen Fluß des Verbundkörpers (1) aufnehmen kann.

3. Spulenkern nach den Ansprüchen 1 und 2, **dadurch gekennzeichnet**, daß eine den Verbundkörper (1) umgebende Spule (4) den weichmagnetischen Körper (5) mitumschließt.

4. Spulenkern nach den Ansprüchen 1 und 2, **dadurch gekennzeichnet**, daß der weichmagnetische Körper (5) U-förmig ausgebildet ist, wobei die beiden Schenkel an den Enden des Verbundkörpers (1) anliegen.

5. Schaltkern nach einem oder mehreren der Ansprüche 1 bis 4, **dadurch gekennzeichnet,** daß der Verbundkörper (1) und der weichmagnetische Körper (5) sandwichförmig zusammengefügt sind.

## Claims

1. A coil core for an inductive frequency-independent switching device comprising a composite body (1) in the form of a wire or a rod which consists of at least two parts (2, 3) which are mechanically braced in relation to one another in the direction of the longitudinal axis of the composite body, and of which at least one is ferromagnetic and possesses, in the direction of the longitudinal axis, anisotropic, soft magnetic properties, where the composite body (1) is assigned an additional, soft magnetic body (5) which is magnetostatically coupled to the composite body (1) and which possesses a lower coercive force than the minimum of one switching, ferromagnetic part (2 and/or 3) of the composite body (1) and via which the stray flux of the composite body (1) is magnetically returned, characterised in that during the switching the magnetization direction in the soft magnetic body (5) is continuously reversed.

2. A coil core as claimed in Claim 1, characterised in that the cross-section of the soft magnetic body (5) is dimensioned such that it can receive the magnetic flux of the composite body (1).

3. A coil core as claimed in Claims 1 and 2, characterised in that a coil (4) surrounding the composite body (1) additionally surrounds the soft magnetic body (5).

4. A coil core as claimed in Claims 1 and 2, characterised in that the soft magnetic body (5) is U-shaped, its two legs bearing against the ends of the composite body (1).

5. A switching core as claimed in one or more of Claims 1 to 4, characterised in that the composite body (1) and the soft magnetic body (5) are assembled in a sandwich formation.

## Revendications

1. Noyau pour un dispositif inductif de commutation, indépendant de la fréquence, avec un corps composite (1) ayant la forme d'un fil ou d'un bâton qui se compose d'au moins deux parties (2, 3) serrées mécaniquement l'une contre l'autre, dans le sens de l'axe longitudinal du corps composite, dont l'une au moins est ferromagnétique et possède dans le sens de l'axe longitudinal des propriétés anisotropes, de champ magnétique faible, noyau dans lequel un corps (5) additionnel magnétique faible, couplé de façon magnétostatique est associé au corps composite, corps (5) qui présente une intensité de champ magnétique plus faible que l'une au moins des parties de couplage ferromagnétique et grâce auquel le flux de dispersion du corps composite (1) est magnétiquement refermé, noyau caractérisé en ce que lors du couplage le sens de magnétisation dans le corps magnétique faible (5) est inversé de façon continue.

2. Noyau selon la revendication 1, caractérisé en ce que la section transversale du corps (5) magnétique faible est dimensionnée de telle façon qu'il peut recevoir le flux magnétique du corps composite (1).

3. Noyau selon les revendications 1 et 2, caractérisé en ce qu'une bobine (4) entourant le corps composite (1) entoure en même temps le corps (5) magnétique faible.

4. Noyau selon les revendications 1 et 2, caractérisé en ce que le corps (5) magnétique faible est constitué en forme d'U, les deux jambes de l'U étant adjacentes aux extrémités du corps composite (1).

5. Noyau selon une ou plusieurs des revendications 1 à 4, caractérisé en ce que le corps composite (1) et le corps (5) magnétique faible basse sont assemblés à la manière d'un sandwich.
